# EUROPEAN PATENT APPLICATION

(11) **EP 4 632 481 A1**
(43) Date of publication of application: **15.10.2025**
(21) Application number: 25164094.2
(22) Date of filing: 17.03.2025
(51) Int. Cl.: G03B 17/55, G03B 17/56, H04N 23/00

(54) **ELECTRONIC DEVICE, COOLING DEVICE, AND ELECTRONIC DEVICE SYSTEM**

(30) Priority: 08.04.2024 JP 2024062190
(71) Applicant: CANON KABUSHIKI KAISHA, Tokyo 146-8501 (JP)
(72) Inventor: AKIMOTO, Takahiro, Tokyo, 146-8501 (JP); SATO, Hideki, Tokyo, 146-8501 (JP); SAKAMAKI, Akihiko, Tokyo, 146-8501 (JP)
(74) Representative: TBK

(57) **Abstract**

To provide an electronic device that can be cooled while suppressing dew condensation on the electronic device with a simple configuration. The electronic device (100) to which a cooling device (200) is detachably attachable, including an electronic component (131, 133) as a heat source, a heat dissipation member (135) having thermal conductivity, and a first heat transfer member (134) configured to thermally connect the electronic component and the heat dissipation member. A heat receiving member (203) of the cooling device and the heat dissipation member are thermally connected in a case where the cooling device is attached to the electronic device.

## Description

### CROSS REFERENCE TO RELATED APPLICATION

This application claims priority from Japanese Patent Application No. 2024-062190, filed on April 8, 2024.

### FIELD OF THE DISCLOSURE

The present disclosure relates to an electronic device to which a cooling device is detachably attachable, the cooling device, and an electronic device system.

### BACKGROUND OF THE DISCLOSURE

Conventionally, since a heat generation amount of an electronic device has increased due to increase in power consumption accompanying higher functionality and miniaturization of electronic components, a heat dissipation configuration that suppresses a rise in temperature is provided in the electronic device.

For example, Japanese Patent Laid-Open Publication No. 2012-198447 (JP2012-198447A) discloses a camera cooling system including a camera as an electronic device and a blower accessory that is attachable to and detachable from the camera. The blower accessory is provided with an air intake/exhaust port communicating with the inside of the camera. The blower accessory is attached to the camera to generate an air flow in an internal space of the camera, thereby cooling the inside and exterior of the camera.

Japanese Patent Laid-Open Publication No. 2009-158803 (JP2009-158803A) discloses a method of cooling a housing of an electronic device by a refrigerant by circulating the refrigerant from a cooling unit provided separately from the electronic device to the electronic device.

However, the technique of JP2012-198447 requires power supply for driving a fan, and thus the configuration is complicated. In the technique disclosed in JP2009-158803A, the electronic device is cooled by circulating the refrigerant, but if the temperature difference between a cooling target component and the refrigerant is large, dew condensation may occur. In addition, since a pump for circulating the refrigerant, a tube, a power source are required, the device becomes complicated.

### SUMMARY OF THE DISCLOSURE

The present disclosure provides a technique for cooling an electronic device while suppressing dew condensation on the electronic device with a simple configuration.

According to a first aspect of the present disclosure, there is provided an electronic device as specified in claim 1. Preferable features of the first aspect of the present disclosure are specified in claims 2 to 11.

According to a second aspect of the present disclosure, there is provided a cooling device as specified in claim 12. Preferable features of the second aspect of the present disclosure are specified in claims 13 to 17.

According to a third aspect of the present disclosure, there is provided an electronic device system as specified in claim 18.

Further features of the present disclosure will become apparent from the following description of exemplary embodiments with reference to the attached drawings.

### BRIEF DESCRIPTION OF THE DRAWINGS

FIG. 1A is a front perspective view showing a camera body as an electronic device according to a first embodiment of the present disclosure.
FIG. 1B is a rear perspective view showing the camera body.
FIG. 1C is a longitudinal sectional view showing a camera body.
FIG. 2A is an external perspective view showing a water-cooled accessory according to the first embodiment.
FIG. 2B is a sectional view along a line A-A in FIG. 2A.
FIG. 3A is a front perspective view showing a camera system according to the first embodiment.
FIG. 3B is a sectional view showing the camera system.
FIG. 4 is a block diagram showing a hardware configuration of the camera system.
FIG. 5A is a rear perspective view showing a camera body as an electronic device according to a second embodiment of the present disclosure.
FIG. 5B is a rear perspective view showing the camera body.
FIG. 5C is a longitudinal sectional view showing the camera body.
FIG. 6A is a rear perspective view showing a water-cooled accessory according to the second embodiment.
FIG. 6B is a view showing the water-cooled accessory viewed from a -Z side.
FIG. 6C is a sectional view along a line B-B in FIG. 6B.
FIG. 7A is a rear perspective view of a camera system according to the second embodiment.
FIG. 7B is a sectional view showing the camera system.
FIG. 8A is a rear view of a camera body as an electronic device according to a third embodiment of the present disclosure.
FIG. 8B is a sectional view along a line C-C in FIG. 8A.
FIG. 9A is a rear perspective view showing a water-cooled accessory according to the third embodiment.
FIG. 9B is a view showing the water-cooled accessory viewed from a +Y side.
FIG. 9C is a sectional view along a line D-D in FIG. 9B.
FIG. 10A is a front perspective view showing a camera system according to the third embodiment.
FIG. 10B is a sectional view along a line E-E in FIG. 10A.
FIG. 11 is a schematic view showing a modification of a containment vessel.
FIG. 12 is a perspective view showing a modification of a heatsink.

### DETAILED DESCRIPTION OF THE PREFERRED EMBODIMENTS

Hereafter, embodiments according to the present disclosure will be described in detail by referring to the drawings.

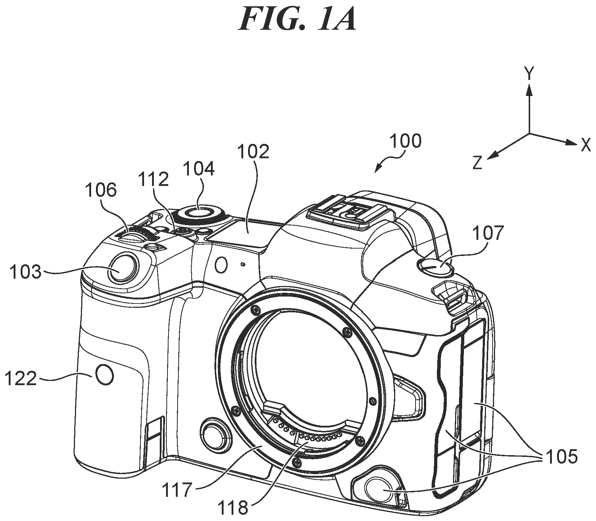

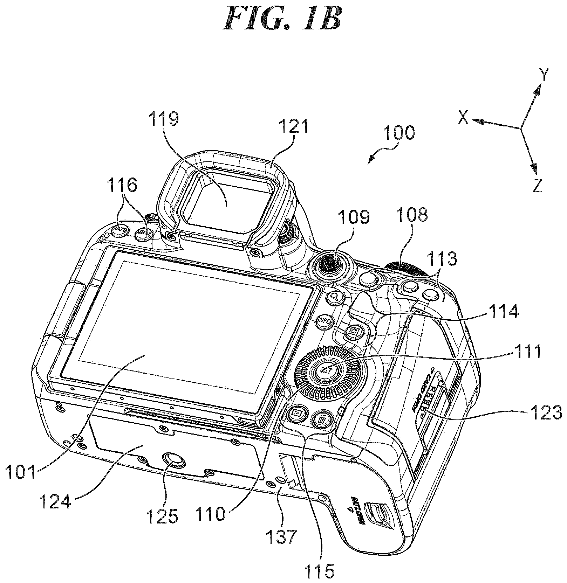

FIGS. 1A and 1B are front and rear perspective views, respectively, showing an electronic device according to a first embodiment of the present disclosure. In the present embodiment, a camera body 100, which is an image capturing apparatus, is exemplified as the electronic device.

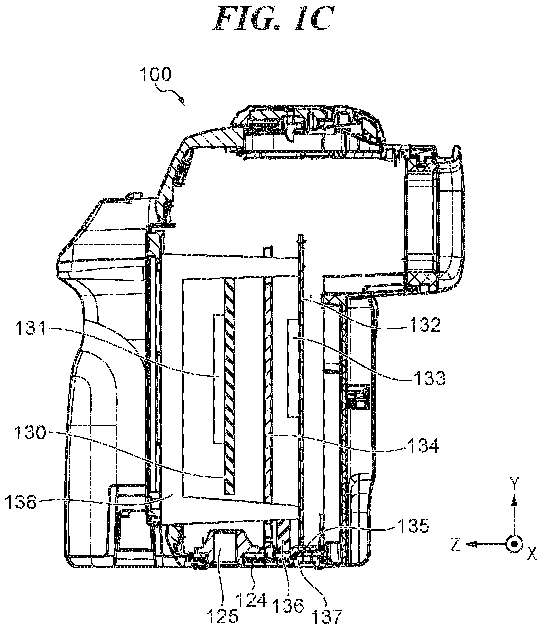

Hereinafter, directions of respective parts are referred to with reference to X, Y, and Z coordinate axes shown in FIGS. 1A, 1B, and 1C. For convenience, an object side in a direction parallel to an optical axis of an interchangeable lens (not shown) attached to the camera body 100 is referred to as a front side. Therefore, for example, a +Y direction is upward and a +Z direction is forward. A +X direction is rightward when viewed from the object side.

FIG. 1C is a longitudinal sectional view showing the camera body 100 in a YZ plane containing the optical axis.

A display unit 101 is provided on the rear of the camera body 100. The display unit 101 is attached to the camera body 100 so as to be capable of opening/closing or rotating, and displays an image generated by image capturing and various kinds of information related to the image capturing. The display unit 101 is equipped with a touch panel, and can detect a touch operation of a user to a display surface (an operation surface).

An out-of-finder display unit 102 provided on a top surface of the camera body 100 can display set values of various image capturing parameters, such as a shutter speed and an aperture value. A shutter button 103 is an operation member operated when the user instructs the camera body 100 to capture an image. A mode change switch 104 is an operation member operated when the user switches various modes.

A terminal cover 105 protects a connector to which a connection cable extending from an external apparatus (not shown) is connected. A main electric dial 106 is an operation member that is rotationally operated when the user changes a set value of an image capturing parameter. A power switch 107 is an operation member operated when the user switches ON/OFF of the power of the camera body 100. A sub electronic dial 108 is an operation member operated when the user moves a selection frame such as a focusing (AF) frame or feeds images.

A multi-controller 109 is provided on the rear of the camera body 100. A multi-controller 109 is configured to allow input by a keytop pressing operation and a keytop tilting operation in the vertical, horizontal, and oblique directions. The user can move the selection frame and select an item in various menus by operating the multi-controller 109.

A rear electronic dial 110 is an operation member operated when the user moves the selection frame or feeds an image. The rear electronic dial 110 is arranged at a position where the user can intuitively and easily operate the rear electronic dial while reproducing a captured image on the display unit 101 and the user can easily operate the rear electronic dial even in a state where the camera body 100 is held vertically. A SET button 111 is provided in the center of the rear electronic dial 110. The SET button 111 is an operation member of a push button type operated when the user determines the selection item.

A moving image button 112 is an operation member operated when the user instructs to start and stop moving image recording. A first button group 113 includes operation members related to focusing and exposure, and includes an AF start button, an AE lock button, and an AF frame selection button arranged in a lateral direction. In an image capturing standby state, the user can start an AF process, change the AF frame, and fix the exposure by pressing the buttons of the first button group 113.

A second button group 114 includes an enlargement/reduction button, an information display button, and a quick setting button arranged in an L shape. The user can switch the enlargement of the live view display image between ON and OFF by operating the enlargement/reduction button in a live view display state in an image capturing mode. The user can switch ON/OFF of enlargement of a captured image in reproducing in a play mode by operating the enlargement/reduction button. The user can switch a method of displaying information on the display unit 101 by operating the information display button. The user can immediately shift a screen on the display unit 101 to a screen on which set values of image capturing parameters are changed by operating the quick setting button.

A third button group 115 includes a play button and an erase button. A user operation of the play button switches a mode between the image capturing mode and the play mode. When the play button is operated in the image capturing mode, the mode is shifted to the play mode and the latest captured image among the captured images recorded in a recording medium (not shown) is displayed on the display unit 101. When the user selects the captured image and operates the erase button in the play mode, the selected captured image is erased.

A fourth button group 116 includes a menu button and a rating button. When the user operates the menu button, a menu screen displaying settable items is displayed on the display unit 101. The user can intuitively select and set items by performing a touch operation on the menu screen displayed on the display unit 101 or operating the multi-controller 109, the rear electronic dial 110, or the SET button 111. When the user operates the rating button in the play mode, rating of a reproduced image can be performed.

An interchangeable lens (not shown) is detachably mounted on a mount 117. A communication terminal 118 provided inside the mount 117 is used for communication between the camera body 100 and the interchangeable lens.

A finder 119 provided on the upper portion of the rear surface of the camera body 100 is an electronic viewfinder, and allows the user looking into the finder to visually recognize a live view display image etc. The finder 119 includes an eye proximity detector, and the eye proximity detector can detect that the user is looking into (is in contact with) the finder 119. An eyepiece cover 121 is a rubber member that comes into contact with a face around an eye of the user looking into the finder 119.

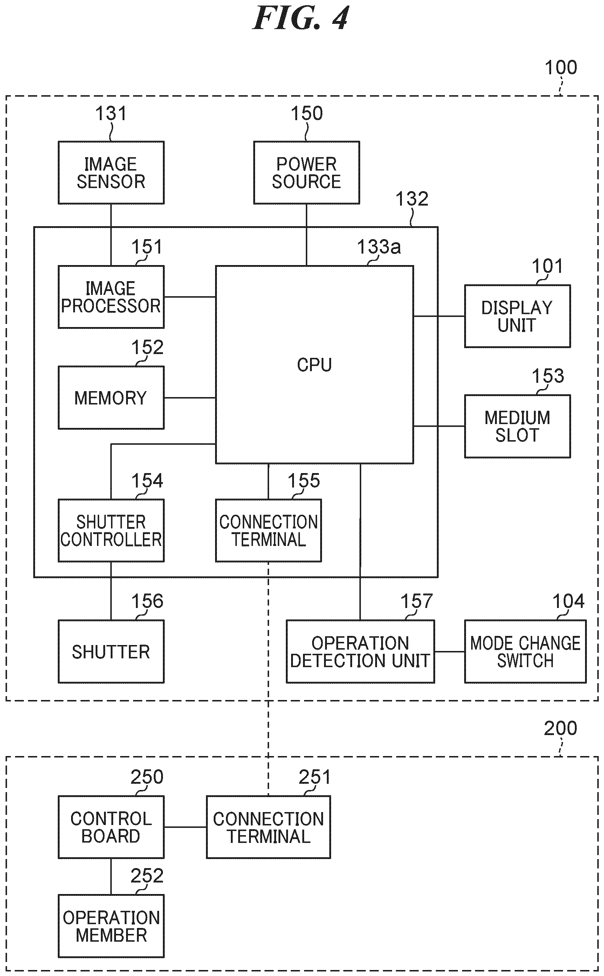

A grip 122 has a shape that is easy for the user who holds the camera body 100 to grip with a right hand. A card lid 123 covers a medium slot 153 (see FIG. 4) for storing a medium. The card lid 123 is provided at a portion of the grip 122 that is touched by a palm of the user.

A tripod mount 125 is an attachment member used to mount an external accessory to the bottom surface of the camera body 100. A bottom exterior member 137 constitutes a portion of the bottom surface of the camera body 100 among the exterior members of the camera body 100. The bottom exterior member 137 has an opening (not shown), that has a shape to which a main body cover 124 can be attached. The main body cover 124 is a protection member that is attached to the opening of the bottom exterior member 137 and protects a heat dissipation member 135 (see FIG. 1C) exposed from the exterior.

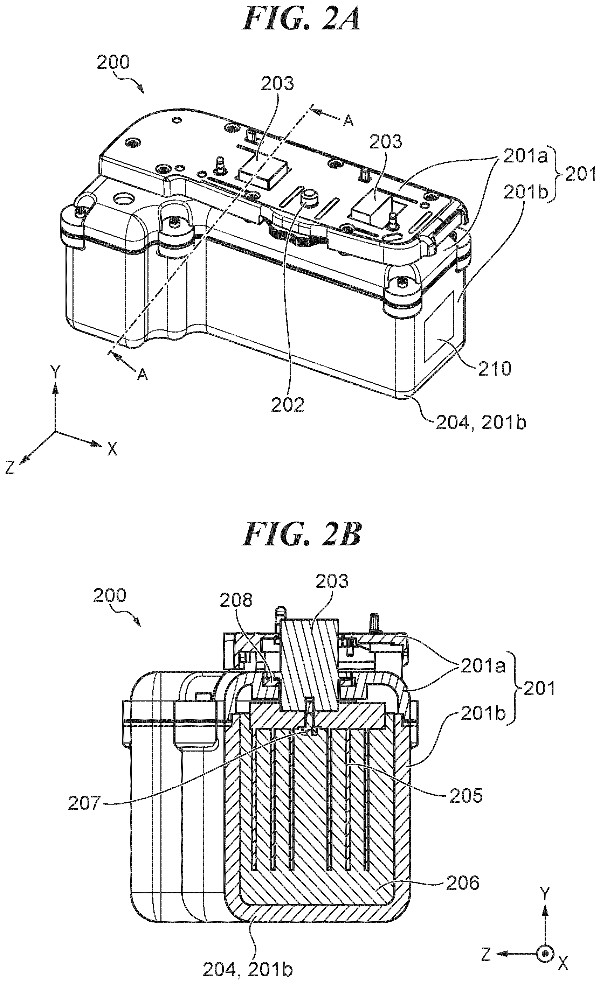

As described later, a water-cooled accessory 200 (FIG. 2A and FIG. 2B) as a cooling device is detachably attached to the camera body 100. First, an internal configuration of the camera body 100 will be described.

As shown in FIG. 1C, an image sensor 131 such as a CMOS or a CCD, which is a heat generation source, is mounted on a first circuit board 130. Electronic components 133 such as a CPU (Central Processing Unit) and a DRAM are mounted on a second circuit board 132 as examples of heat sources. A first heat transfer member 134 made of a high thermal conductivity member, such as an aluminum sheet metal, a copper sheet metal, or a heat pipe, is disposed between the first circuit board 130 and the second circuit board 132 in the Z direction.

The image sensor 131 and the first heat transfer member 134 on the first circuit board 130 are thermally connected by an unshown heat transfer member such as a heat dissipation rubber or a graphite sheet. The heat of the image sensor 131 on the first circuit board 130 is transmitted to the first heat transfer member 134 via the unshown heat transfer member.

The electronic components 133 on the second circuit board 132 and the first heat transfer member 134 are thermally connected by an unshown heat transfer member such as a heat dissipation rubber or a graphite sheet. The heat of the electronic components 133 on the second circuit board 132 is transmitted to the first heat transfer member 134 via the unshown heat transfer member.

The first heat transfer member 134 and the heat dissipation member 135 are thermally connected by screws (not shown). Therefore, the heat of the image sensor 131 and the electronic components 133, which are main heat sources, is transferred to the heat dissipation member 135 via the first heat transfer member 134.

Although the sheet metal is used as the first heat transfer member 134 in the present embodiment, another heat transfer member like a graphite sheet may be used. Alternatively, the heat may be directly transferred from the first circuit board 130 and the second circuit board 132 to the heat dissipation member 135 using a heat transfer member different from the first heat transfer member 134.

The heat dissipation member 135 is thermally conductive. The heat dissipation member 135 is formed of high thermal conductivity material such as aluminum, magnesium, or copper. The main body cover 124 is an example of a lid member that is attachable to and detachable from the bottom exterior member 137. In a state where the main body cover 124 is detached, a portion of the heat dissipation member 135 is exposed through the opening of the bottom exterior member 137. In a state where the main body cover 124 is attached to the opening of the bottom exterior member 137, the main body cover 124 covers the heat dissipation member 135, and the heat dissipation member 135 is not exposed through the bottom exterior member 137.

Attachment of the main body cover 124 in a state where the water-cooled accessory 200 is not attached prevents the user from inadvertently touching the exposed portion heated of the heat dissipation member 135, which reduces uncomfortable feeling. Alternatively, a recess amount of the exposed portion of the heat dissipation member 135 exposed through the opening of the bottom exterior member 137 may be increased without providing the main body cover 124 so that the user is less likely to touch the exposed portion heated carelessly.

A main construction 138 includes main components constituting the camera body 100 other than the heat dissipation member 135. The heat dissipation member 135 and the main construction 138 are thermally connected via a second heat transfer member 136 formed of a heat dissipation rubber, a graphite sheet, or the like. The heat transferred from the image sensor 131 and the electronic components 133 to the heat dissipation member 135 is transferred to the main construction 138 via the second heat transfer member 136, and is transferred to the entire camera body 100 via the main construction 138.

This reduces accumulation of the heat from the image sensor 131 and the electronic components 133 in the heat dissipation member 135 in the state where the water-cooled accessory 200 is not attached, which prevents excessive temperature rise of the image sensor 131 and the electronic components 133. The heat transferred to the heat dissipation member 135 may be transferred not only to the main construction 138 but also to exterior members or an internal member such as a sheet metal.

Note that a plurality of second heat transfer members 136 may be provided to transfer the heat of the heat dissipation member 135 to the entire camera body 100. For example, the heat of the heat dissipation member 135 may be transferred to the main construction 138 at a plurality of spots instead of only one spot. Alternatively, the second heat transfer members 136 may be provided at a plurality of spots so as to transfer the heat to the exterior members or other members in addition to the main construction 138.

In the present embodiment, the bottom exterior member 137 and the heat dissipation member 135 are disposed at the bottom of the camera body 100. However, the arrangement is not limited thereto. They may be arranged on a plane orthogonal to a thickness direction (Z direction) of the first circuit board 130 and the second circuit board 132. For example, they may be arranged at the upper surface or the side surface of the camera body 100.

FIG. 2A is an external perspective view showing the water-cooled accessory 200. FIG. 2B is a sectional view along a line A-A in FIG. 2A. Directions about the water-cooled accessory 200 are based on the state in which the water-cooled accessory 200 is attached to the camera body 100.

The configuration of the water-cooled accessory 200 will be described. The water-cooled accessory 200 includes an accessory exterior 201, a tripod screw 202, and a pair of accessory heat receiving members 203 (FIG. 2A). The accessory exterior 201 is an exterior member constituting the exterior of the water-cooled accessory 200, and is constituted by an upper accessory exterior 201a and a lower accessory exterior 201b.

A part of each of the accessory heat receiving members 203 is exposed from the upper accessory exterior 201a. That is, each of the accessory heat receiving members 203 is exposed to protrude upward (+Y side) from the upper accessory exterior 201a in a convex shape. Note that, although the two accessory heat receiving members 203 are provided, this is not limited. For example, the accessory heat receiving member 203 may be provided at one position or the accessory heat receiving members 203 may be provided at three or more positions in accordance with an arrangement region of the heat dissipation member 135 provided in the camera body 100.

The water-cooled accessory 200 further includes a containment vessel 204 (containment unit). The containment vessel 204 contains a refrigerant 206 and a heatsink 205 (thermal diffuser) that transmits heat to the refrigerant 206 (FIG. 2B).

**In** the present embodiment, the containment vessel 204 also serves as the lower accessory exterior 201b. However, this is not limited, and the accessory exterior 201 may be provided outside the containment vessel 204. In this case, the containment 204 is fixed to the accessory exterior 201 with screws (not shown) and thermally connected.

The accessory heat receiving members 203 and the heatsink 205 are fixed and thermally connected with a heatsink fixing member 207. The heatsink 205 and the refrigerant 206 are thermally connected. The accessory heat receiving members 203 receive heat inside the camera body 100 and also serves as a heat transfer path for transferring the heat to the heatsink 205.

In the present embodiment, the accessory heat receiving members 203 and the heatsink 205 are separate components. However, the accessory heat receiving members 203 and the heatsink 205 may be integrally constituted without using the heatsink fixing member 207.

The accessory heat receiving member 203 is attached to penetrate the upper accessory exterior 201a, and has a liquid seal 208 so that the refrigerant 206 does not flow out to the outside. The liquid seal 208 is formed of elastic material and enables fine adjustment of the position of the accessory heat receiving member 203 in the vertical direction (Y direction). Therefore, the liquid seal 208 plays a role of increasing adhesion between the heat dissipation member 135 of the camera body 100 and the accessory heat receiving member 203 of the water-cooled accessory 200 and reducing thermal resistance.

The heatsink 205 has a plurality of fins for efficiently transferring heat to the refrigerant 206. In order to ensure heat dissipation regardless of the orientation (posture) of the water-cooled accessory 200, the fins of the heatsink 205 are arranged so as not to be exposed to air in any posture and so as to be sunk in the refrigerant 206. The heatsink 205 can more efficiently transfer heat to the refrigerant 206 by increasing the surface area of the fins. Therefore, the pitch and length of the fins of the heatsink 205 are designed to be optimal in accordance with the size of the containment vessel 204 and the type of the refrigerant 206.

The refrigerant 206 is water as an example, but may be another liquid having a larger heat capacity. Water expands by freezing at low temperatures. When the refrigerant 206 is water, the refrigerant 206 may be put into the containment vessel 204 in a small amount in consideration of expansion due to solidification in order to prevent the containment vessel 204 from being damaged due to solidification at low temperatures. This can reduce the possibility of damage to the containment vessel 204 even when the refrigerant 206 solidifies at low temperatures. Note that the refrigerant 206 may be a medium with a low freezing point such as ethylene glycol. Use of the medium having the low freezing point enables to take measures against expansion due to solidification described above.

Since the containment vessel 204 and the heatsink 205 are always contact with the refrigerant 206, it is desirable to select the materials of the containment vessel 204 and the heatsink 205 in accordance with the type of the refrigerant 206. For example, when ethylene glycol is used as the refrigerant 206, metal is suitable for the materials of the containment vessel 204 and the heatsink 205 because ethylene glycol is an organic solvent. When water is used as the refrigerant 206, the containment vessel 204 and the heatsink 205 may be made of material that is hard to rust or may be coated with a rust preventive.

A camera system 1000 (an electronic device system) is configured by attaching the water-cooled accessory 200 to the camera body 100.

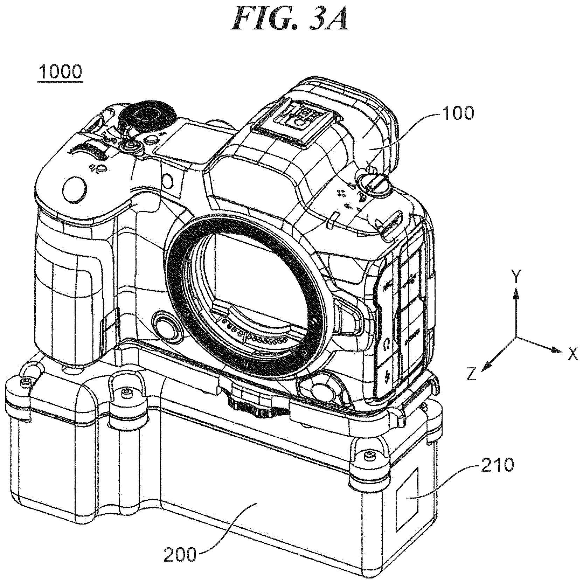

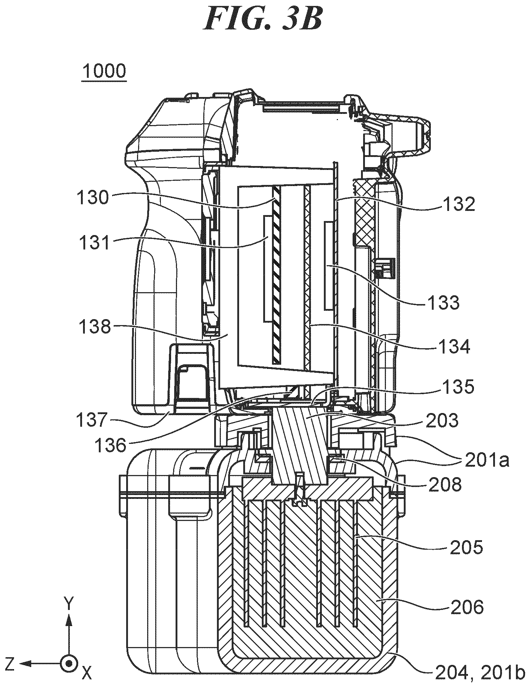

FIG. 3A is a front perspective view showing the camera system 1000 configured by attaching the water cooled accessory 200 to the camera body 100. FIG. 3B is a sectional view of the camera system 1000 with the same cross section as FIG. 2B.

The water-cooled accessory 200 is configured to be attached to and detached from the bottom surface of the camera body 100. When the water-cooled accessory 200 is attached, the user removes the main body cover 124 (FIG. 1B) from the camera body 100 so that the heat dissipation member 135 can be seen from the outside. Therefore, the portion of the heat dissipation member 135 is exposed from the bottom exterior member 137. The user can attach the water-cooled accessory 200 to the camera body 100 by screwing a tripod screw 202 (FIG. 1C) of the water-cooled accessory 200 into the tripod mount 125 (FIG. 2A) of the camera body 100.

When the water-cooled accessory 200 is attached to the camera body 100, the heat dissipation member 135 of the camera body 100 and the accessory heat receiving member 203 of the water-cooled accessory 200 are in contact and thermally connected to each other. This allows transfer of the heat from the camera body 100 to the water-cooled accessory 200.

The water-cooled accessory 200 is provided with a body cover storage portion 210 (FIG. 3A). The body cover 124 removed from the camera body 100 can be stored in the body cover storage portion 210. The user stores the body cover 124, which is removed from the camera body 100 to attach the water-cooled accessory 200, in the body cover storage portion 210, thereby improving convenience.

How heat is transferred will be described in detail. Heat of the image sensor 131 and the electronic components 133 of the camera body 100 is transferred to the heat dissipation member 135 via an unshown heat transfer member and the first heat transfer member 134. **In** a state where the water-cooled accessory 200 is attached to the camera body 100, the heat of the heat dissipation member 135 of the camera body 100 is transmitted to the accessory heat receiving members 203 of the water-cooled accessory 200.

The heat transferred to the accessory heat receiving members 203 is transferred to the heatsink 205, and further transferred from the heatsink 205 to the refrigerant 206. The heat of the refrigerant 206 is transferred to the containment vessel 204 (lower accessory exterior 201b) and is radiated from the outer surfaces of the lower accessory exterior 201b into an atmosphere.

The heat capacity of water is significantly higher than that of metal of a similar volume. When water is used as the refrigerant 206, the refrigerant 206 can store a large amount of heat. Thus, the heat of the image sensor 131 and the electronic components 133 of the camera body 100 can be efficiently stored in the refrigerant 206, and the temperature rise of the image sensor 131 and the electronic components 133 can be suppressed to extend image-capturing available time.

In a typical circulating water cooling system, the cooled refrigerant directly cools the heat generating parts within the camera body 100, which may cause dew condensation due to rapid cooling. In contrast, in the present embodiment, the cooled refrigerant is not directly transferred to the heat generating portion, but the heat of the camera body 100 is transferred to the water-cooled accessory 200 to cool indirectly, and therefore, the image sensor 131 and the electronic components 133 are unlikely to be rapidly cooled. Therefore, the possibility of dew condensation on the image sensor 131 and the electronic components 133 can be reduced. Further, since a pump, a power source, and a tube for circulating a refrigerant required in the circulation type water cooling are not required, the configuration is simple.

As described above, in the camera body 100, the heat transferred to the heat dissipation member 135 is transferred to the entire camera body 100 via the second heat transfer member 136 and the main construction 138. This can reduce the problem that the heat stays in the heat dissipation member 135 and the heat of the image sensor 131 and the electronic components 133 is less likely to decrease when the water-cooled accessory 200 is not attached.

On the other hand, when the water-cooled accessory 200 is attached to the camera body 100, the heat is transferred to a lower temperature side, and thus the heat of the camera body 100 is transferred to the water-cooled accessory 200, and thus it is possible to suppress an increase in temperature of the camera body 100.

FIG. 4 is a block diagram showing a hardware configuration of the camera system 1000 (the camera body 100 and the water-cooled accessory 200).

In the camera body 100, a CPU 133a is included in the electronic components 133. The CPU 133a sends various instructions to circuit units to control the operation of the entire camera body 100. Various heat generating components such as the electronic components 133 are mounted on the second circuit board 132. The second circuit board 132 is a PWB (Printed Wired Board), and many of various electric circuits (detection circuit, control circuit, and processing circuit) including a camera microcomputer are mounted thereon. The CPU 133a controls each function block of the camera body 100 and performs necessary operations for the control in accordance with a computer program loaded from a memory 152.

A power supply 150 supplies power to each circuit in the camera body 100. The image sensor 131 is constituted by a CCD or CMOS sensor, and converts an optical image of an object into an image signal. The image signal obtained by the image sensor 131 is converted into image data by an image processor 151 and output to the CPU 133a. The memory 152 stores captured images and various data.

A shutter 156 is disposed in front of the image sensor 131. The shutter 156 controls an exposure time of the image sensor 131. A shutter controller 154 drives the shutter 156 on the basis of a signal input from the CPU 133a. The mode change switch 104 is operated by a user. When the mode change switch 104 is operated, an operation detection unit 157 outputs a signal to the CPU 133a, and image capturing conditions, such as exposure and shutter speed, are changed.

The water-cooled accessory 200 includes an operation member 252 for setting various image capturing conditions of the camera body 100 similarly to the camera body 100. An operation signal of the operation member 252 is transmitted to the CPU 133a on the second circuit board 132 via a control board 250, a connection terminal 251, and a connection terminal 155 of the camera body 100.

The camera body 100 can select a desired moving image capturing mode from among a plurality of moving image capturing modes in accordance with the operations of the mode change switch 104 and the operation member 252. The moving image capturing modes include, for example, a high image quality mode and a low image quality mode. When a moving image is captured in the high image quality mode, the load of processes performed by the image sensor 131 and the CPU 133a is large, and therefore, heat generation of these electronic components and heat generation in a medium slot 153 become also large, which shortens a moving-image-capturing available time. On the other hand, in the low image quality mode, the heat generation of these components is smaller than that in the high image quality mode, and the moving-image-capturing available time becomes longer.

According to the present embodiment, the electronic components 133 in the camera body 100 and the heat dissipation member 135 are thermally connected. When the water-cooled accessory 200 is attached to the camera body 100, the accessory heat receiving member 203 and the heat dissipation member 135 are thermally connected to each other, and thus the heat of the electronic components 133 is transferred to the refrigerant 206. Thus, the camera body 100 can be cooled while suppressing the dew condensation of the camera body 100 (electronic device) with a simple configuration.

In the present embodiment, the heat in the containment vessel 204 is dissipated to the outside from the outer surface of the containment vessel 204. In contrast, a heat insulating structure that does not transfer the heat from the inner surface to the outer surface of the containment vessel 204 may be employed. In this way, even when the ambient temperature is high, the refrigerant 206 in the containment vessel 204 is not affected by the high temperature and can perform the cooling function.

It is not essential that the refrigerant 206 in the containment vessel 204 is replaceable. However, a configuration in which the refrigerant is replaceable by providing a separate refrigerant replacement unit may be employed. In a case where the refrigerant 206 replaceable, the containment vessel 204 can be emptied when the refrigerant 206 is not needed, such as when carrying it, which improves convenience.

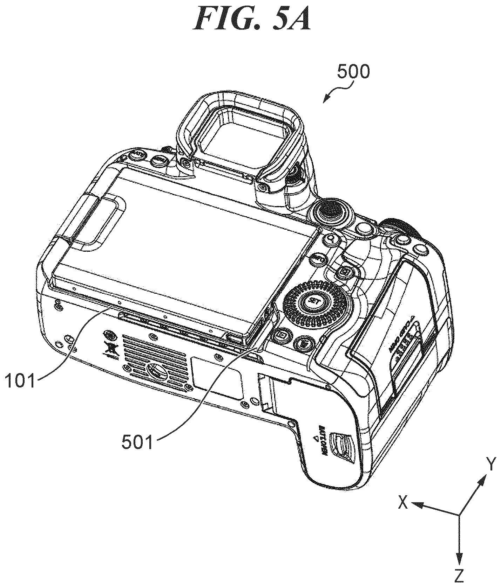

A second embodiment of the present disclosure will now be described with reference to FIGS. 5A to 7B. In the drawings, the same components as those of the first embodiment are denoted by the same reference numerals.

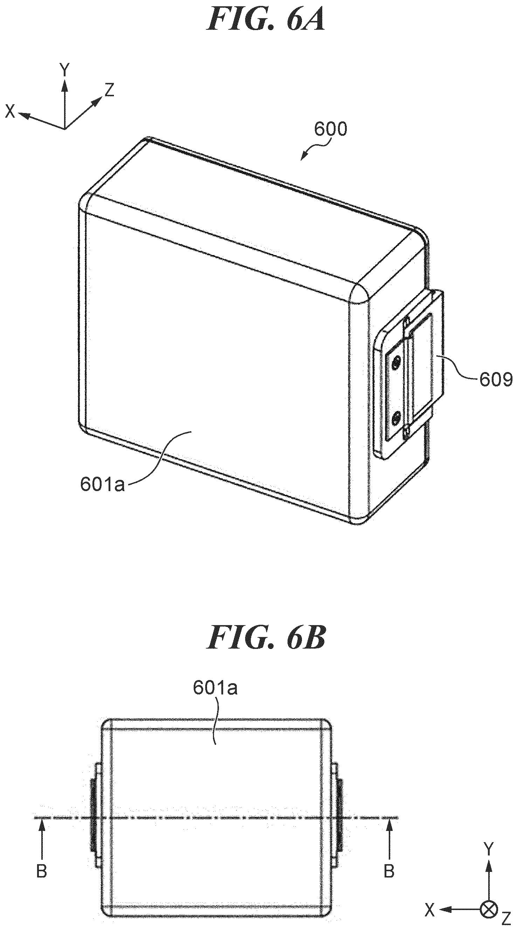

**In** the present embodiment, a camera body 500 is exemplified as the electronic device, and a water-cooled accessory 600 (FIG. 6A, etc.) is exemplified as the cooling device. Hereinafter, directions of respective parts are referred to with reference to X, Y, and Z coordinate axes shown in FIG. 5A etc. The directions of the water-cooled accessory 600 are based on the state in which the water-cooled accessory 600 is attached to the camera body 500.

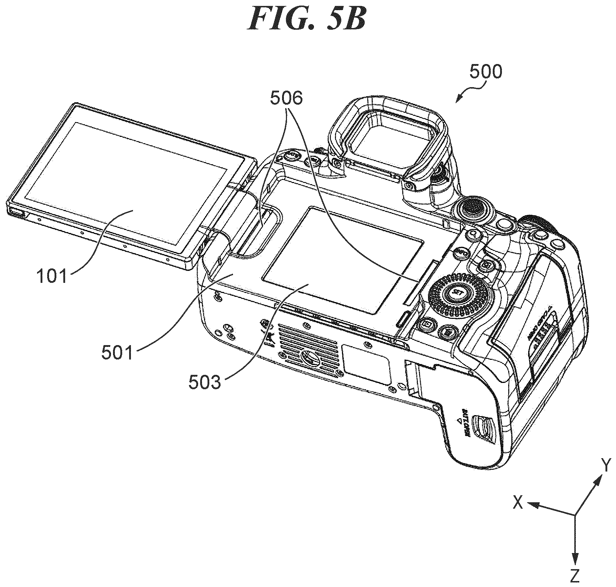

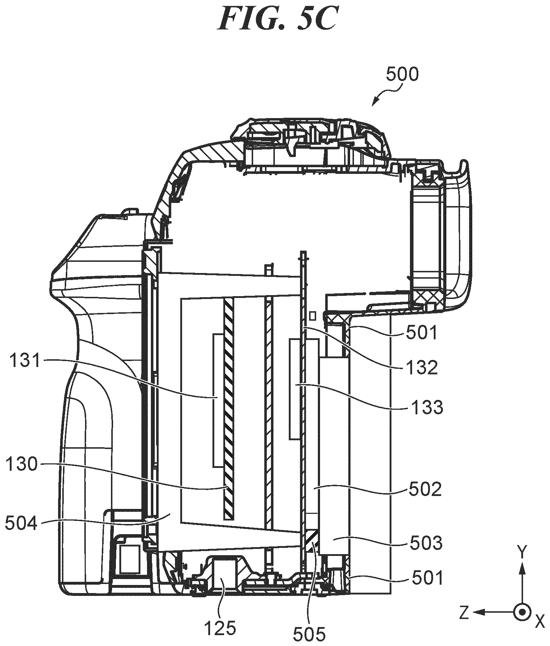

FIGS. 5A and 5B are rear perspective views showing the camera body 500. FIG. 5A shows a state in which the display unit 101 is closed, and FIG. 5B shows a state in which the display unit 101 is opened. FIG. 5C is a vertical sectional view of the camera body 500 in the YZ plane containing the optical axis.

As shown in FIGS. 5A and 5B, the display unit 101 is movably attached to a rear exterior member 501 that constitutes a portion of the rear surface of the camera body 500. The display unit 101 is movable between a position overlapping the rear surface of the camera body 500 and a position not overlapping the rear surface. The rear exterior member 501 contains the display unit 101 when it is closed. A heat dissipation member 503 and a pair of lock members 506 are disposed in a concave portion of the rear exterior member 501. When the display unit 101 is opened, the heat dissipation member 503 is visible in the rear exterior member 501. That is, when the display unit 101 is closed and moved to the position overlapping the rear surface of the camera body 500, the heat dissipation member 503 is not exposed, and when the display unit 101 is opened and moved to the position not overlapping the rear surface, a portion of the heat dissipation member 503 is exposed.

As shown in FIG. 5C, the image sensor 131 such as a CMOS or CCD sensor, which is a heat generation source, is mounted on the first circuit board 130. The electronic components 133 such as a CPU and a DRAM, which are heat sources, are mounted on the second circuit board 132.

The rear exterior member 501 is provided to be orthogonal to the Z direction on a -Z side of the second circuit board 132. The portion of the heat dissipation member 503 made of high thermal conductivity material, such as aluminum, magnesium, or copper, is exposed from the rear exterior member 501. Although the heat dissipation member 503 and the lock members 503 are provided on the rear surface of the camera body 500 in the present embodiment, they may be disposed on a front surface of the camera body 500.

The electronic components 133 on the second circuit board 132 and the heat dissipation member 503 are thermally connected by a first heat transfer member 502, such as a heat dissipation rubber or a graphite sheet. The first heat transfer member 502 transfers the heat from the electronic components 133 on the second circuit board 132 to the heat dissipation member 503.

As shown in FIG. 5C, the electronic components 133 are mounted on the opposite side of the second circuit board 132 from the heat dissipation member 503 in the Z direction. Therefore, the first heat transfer member 502 and the electronic components 133 are arranged at positions facing each other across the second circuit board 132, and the heat is transferred to the heat dissipation member 503 via the second circuit board 132.

However, this is not limited, and the electronic components 133 may be mounted on the -Z side surface of the second circuit board 132. In this case, the first heat transfer member 502 may be disposed between the electronic components 133 and the heat dissipation member 503, and the heat of the electronic components 133 may be transferred to the heat dissipation member 503 without passing through the second circuit board 132.

The image sensor 131 and the heat dissipation member 503 may be thermally connected by an unshown heat transfer member, such as a heat dissipation rubber or a graphite sheet. Thus, the heat of the image sensor 131 is transferred to the heat dissipation member 503.

As shown in the FIG. 5A, the display unit 101 is at the position overlapping the heat dissipation member 503 when not in use, as viewed from the Z direction. Therefore, when the water-cooled accessory 600 (FIG. 6A) is not attached, the display unit 101 is closed and overlapped with the heat dissipation member 503, and thus it is possible to reduce discomfort caused by the user inadvertently touching the heat dissipation member 503 that becomes hot. A body cover may be attached to the rear exterior member 501 so as to cover the exposed portion of the heat dissipation member 503.

A main construction 504 is a main component that constitutes the camera body 500. The heat dissipation member 503 and the main construction 504 are thermally connected by a second heat transfer member 505, such as a heat dissipation rubber or a graphite sheet, and the second circuit board 132. The heat transferred from the image sensor 131 and the electronic components 133 to the heat dissipation member 503 is transferred to the main construction 504 via the second heat transfer member 505, and is transferred to the entire camera body 500 via the main construction 504.

Accordingly, when the water-cooled accessory 600 is not attached, the heat of the image sensor 131 and the electronic components 133 is prevented from being accumulated in the heat dissipation member 503, and thus, the temperature of the image sensor 131 and the electronic components 133 is prevented from excessively increasing. The heat transferred to the heat dissipation member 503 may be transferred not only to the main construction 504 but also to an exterior member or an internal member such as a sheet metal.

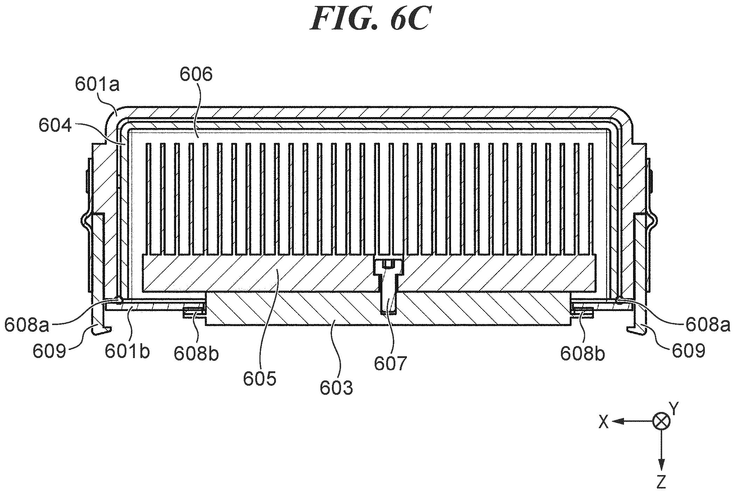

FIG. 6A is a rear perspective view of the water-cooled accessory 600. FIG. 6B is a view showing the water-cooled accessory 600 viewed from the -Z side. FIG. 6C is a sectional view along a line B-B in FIG. 6B.

As shown in FIG. 6C, the water-cooled accessory 600 includes accessory exteriors 601a and 601b, an accessory heat receiving member 603, and a pair of lock claws 609. The accessory heat receiving member 603 is exposed to protrude in a convex shape from the accessory exterior 601b to a +Z side. Although only one accessory heat receiving member 603 is provided in the present embodiment, this is not limited, and a plurality of accessory heat receiving members may be provided.

The water-cooled accessory 600 includes a containment vessel 604 (containment unit) that contains a refrigerant 606, and a heatsink 605 that transfers heat to the refrigerant 606 in the containment vessel 604. The containment vessel 604 and the heatsink 605 are housed in the accessory exteriors 601a and 601b.

The accessory heat receiving member 603 and the heatsink 605 are fixed and thermally connected to each other by a heatsink fixing member 607. The heatsink 605 and the refrigerant 606 are thermally connected to each other. The accessory heat receiving member 603 receives heat inside the camera body 500 and also serves as a heat transfer path for transferring heat to the heat sink 605.

The accessory heat receiving member 603 is attached to penetrate the accessory exterior 601b, and has liquid seals 608a and 608b so that the refrigerant 606 inside the containment vessel 604 does not flow out to the outside. The liquid seals 608a and 608b are formed of elastic material and enable fine adjustment of the position of the accessory heat receiving member 603 in a front-rear direction (the Z direction). Therefore, the liquid seals 608a and 608b play a role of increasing adhesion between the heat dissipation member 503 of the camera body 500 and the accessory heat receiving member 603 and reducing thermal resistance.

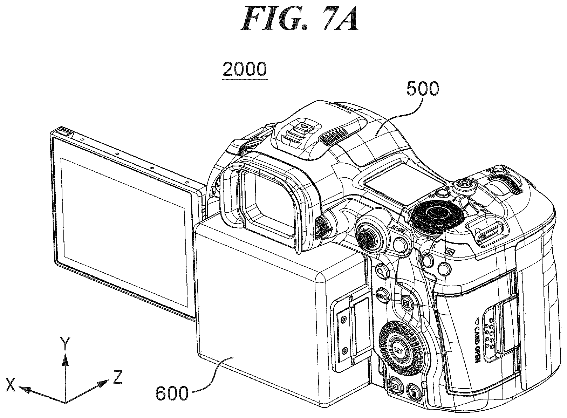

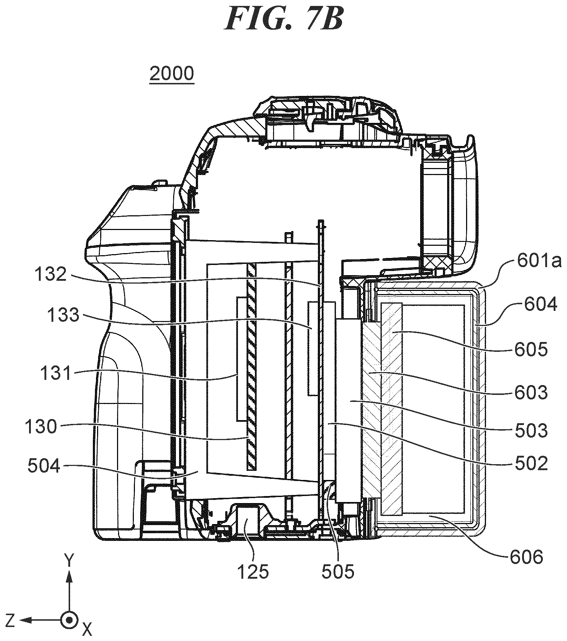

FIG. 7A is a rear perspective showing a camera system 2000 configured by attaching the water-cooled accessory 600 to the camera body 500. FIG. 7B is a sectional view showing the camera system 2000 with the same cross section as FIG. 5C.

As shown in FIG. 7A, the water-cooled accessory 600 is configured to be removably attached to the rear surface of the camera body 500. The camera body 500 and the water-cooled accessory 600 are fixed by engagement between the lock members 506 (FIG. 5B) of the camera body 500 and the lock claws 609 (FIG. 6C) of the water-cooled accessory 600.

If the volume of the refrigerant 606 is large, the water-cooled accessory 600 becomes heavy and the lock members 506 and the lock claws 609 alone may not be able to maintain a sufficient holding force against the rear surface of the camera body 500. In such a case, the accessory exterior 601a of the water-cooled accessory 600 may be extended to the bottom of the camera body 500, and a tripod screw (not shown) may be screwed into the tripod mount 125 (FIG. 7B) of the camera body 500 to fix the water-cooled accessory 600 to the camera body 500. Alternatively, the engagement between the lock members 506 and the lock claws 609 and the screwing between the tripod mount 125 and the tripod screw may be used in combination.

When the water-cooled accessory 600 is attached, the user opens the display unit 101 to allow the heat dissipation member 503 to be visible from the outside (FIG. 5B). In the state where the portion of the heat dissipation member 503 is exposed from the rear exterior member 501, the user attaches the water-cooled accessory 600 to the camera body 500 by engaging the lock members 506 and the lock claws 609.

When the water-cooled accessory 600 is attached to the camera body 500, the heat dissipation member 503 of the camera body 500 and the accessory heat receiving member 603 of the water-cooled accessory 600 are in contact and thermally connected to each other. This allows the heat from the camera body 500 to be transferred to the water-cooled accessory 600.

How heat is transferred will be described in detail. Heat of the image sensor 131 and the electronic components 133 of the camera body 500 is transferred to the heat dissipation member 503 via an unshown heat transfer member and the first heat transfer member 502. **In** a state where the water-cooled accessory 600 is attached to the camera body 500, the heat of the heat dissipation member 503 is transmitted to the accessory heat receiving member 603 of the water-cooled accessory 600.

The heat transferred to the accessory heat receiving member 603 is transferred to the heatsink 605, and further transferred from the heatsink 605 to the refrigerant 606. The heat of the refrigerant 606 is transferred to the containment vessel 604, is transferred from the containment vessel 604 to the accessory exterior 601a, and is radiated from the outer surface of the accessory exterior 601a into the atmosphere. **In** contrast, a heat insulating structure that does not transfer the heat from the containment vessel 204 to the accessory exterior 601a may be employed.

According to the present embodiment, when the water-cooled accessory 600 is attached to the camera body 500, the heat dissipation member 503 and the accessory heat receiving member 603 are thermally connected to each other, and thus the heat of the electronic components 133 is transferred to the refrigerant 606. Therefore, the same effect as that of the first embodiment can be achieved in cooling the camera body 500 while suppressing the dew condensation of the camera body 500 with a simple configuration.

Further, since the heat dissipation member 503 is disposed on the rear surface of the camera body 500, the heat of the electronic components 133 on the second circuit board 132 which constitute a main heat source can be transferred to the heat dissipation member 503 of the rear exterior member 501 through the shortest path, and further transferred to the accessory heat receiving member 603.

The rear exterior member 501 is a member that can secure a relatively large area among exterior members of the camera body 500. Therefore, the area of the heat dissipation member 503 that is in contact with the accessory heat receiving member 603 of the water-cooled accessory 600 can be increased, and the heat can be more efficiently dissipated to the water-cooled accessory 600.

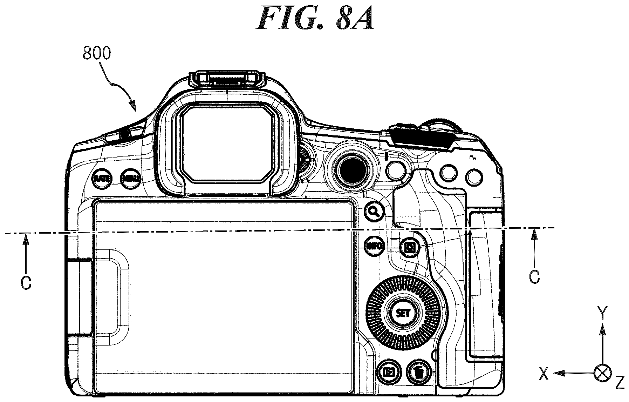

A third embodiment of the present disclosure will now be described with reference to FIGS. 8A to 10B. In the drawings, the same components as those of the first embodiment are denoted by the same reference numerals.

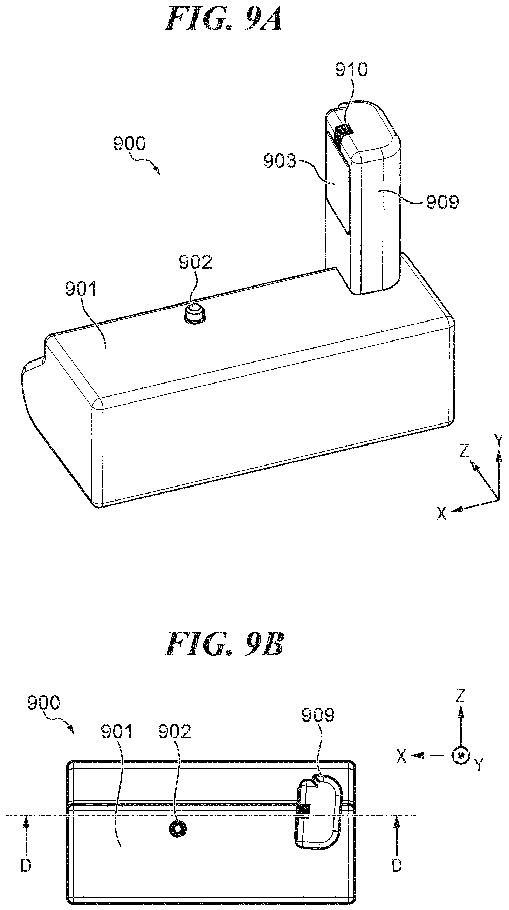

In the present embodiment, a camera body 800 is exemplified as the electronic device, and a water-cooled accessory 900 (FIG. 9A etc.) is exemplified as the cooling device. Hereinafter, directions of respective parts are referred to with reference to X, Y, and Z coordinate axes shown in FIG. 8A etc. Directions about the water-cooled accessory 900 are based on the state in which the water-cooled accessory 900 is attached to the camera body 800.

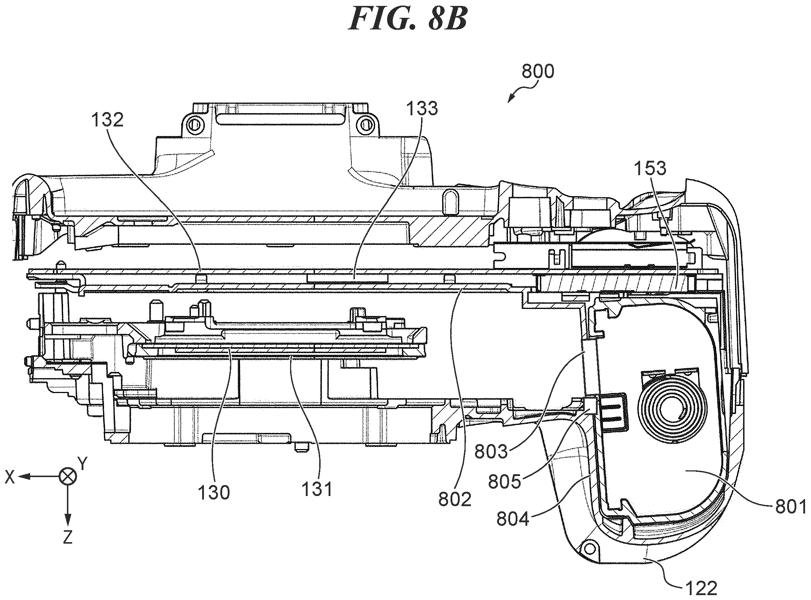

FIG. 8A is a rear view showing the camera body 800. FIG. 8B is a sectional view along a line C-C in FIG. 8A.

The image sensor 131 such as a CMOS or CCD sensor, which is a heat generation source, is mounted on the first circuit board 130. The electronic components 133, such as a CPU and a DRAM, and the medium slot 153, which are heat generation sources, are mounted on the second circuit board 132.

A first heat transfer member 802 made of a high thermal conductivity member, such as an aluminum sheet metal, a copper sheet metal, or a heat pipe, is disposed between the first circuit board 130 and the second circuit board 132 in the Z direction.

The image sensor 131 on the first circuit board 130 and the first heat transfer member 802 are thermally connected by an unshown heat transfer member, such as a heat dissipation rubber or a graphite sheet. The heat of the image sensor 131 on the first circuit board 130 is transmitted to the first heat transfer member 802 via the unshown heat transfer member.

The electronic components 133 on the second circuit board 132 and the first heat transfer member 802 are thermally connected by an unshown heat transfer member, such as a heat dissipation rubber or a graphite sheet. The heat of the electronic components 133 on the second circuit board 132 is transmitted to the first heat transfer member 802 via the unshown heat transfer member. The medium slot 153 on the second circuit board 132 and the first heat transfer member 802 may be thermally connected by an unshown heat transfer member, such as a heat dissipation rubber or a graphite sheet.

A battery chamber 801 to contain a battery that supplies power to the camera body 800 is provided inside the grip 122 of the camera body 800.

The battery chamber 801 may be made of aluminum, magnesium, or resin. A portion of a heat dissipation member 803 thermally connected to the first heat transfer member 802 is exposed in the battery chamber 801. The heat dissipation member 803 is made of high thermal conductivity material, such as aluminum, magnesium, or copper.

Although the battery chamber 801 and the heat dissipation member 803 are provided separately in the present embodiment, the entire battery chamber 801 may be made of material such as aluminum or magnesium, and the entire battery chamber 801 may also serve as a role of the heat dissipation member 803. The first heat transfer member 802 and the heat dissipation member 803 are thermally connected to each other by screws (not shown), and the heat of the image sensor 131 and the electronic components 133 is transmitted to the heat dissipation member 803 via the first heat transfer member 802.

Although the first heat transfer member 802 uses a sheet metal in the present embodiment, a graphite sheet or another heat transfer member can be used. Further, the heat may be transferred from the first circuit board 130 and the second circuit board 132 to the heat dissipation member 803 using a heat dissipation member different from the first heat transfer member 802.

A main construction 804 is a main component that constitutes the camera body 800. The heat dissipation member 803 and the main construction 804 are thermally connected by a second heat transfer member 805 such as a heat dissipation rubber or a graphite sheet. The heat transferred from the image sensor 131 and the electronic components 133 to the heat dissipation member 803 is transferred to the main construction 804 via the second heat transfer member 805, and is transferred to the entire camera body 800 via the main construction 804.

This reduces accumulation of the heat from the image sensor 131 and the electronic components 133 in the heat dissipation member 803 in the state where the water-cooled accessory 900 is not attached, which prevents excessive temperature rise of the image sensor 131 and the electronic components 133. The heat transferred to the heat dissipation member 803 may be transferred not only to the main construction 804 but also to exterior members or an internal member such as a sheet metal.

Since the heat dissipation member 803 is exposed within the battery chamber 801, the user cannot touch the heat dissipation member 803 easily. Therefore, it is possible to prevent the user from feeling uncomfortable by inadvertently touching the heat dissipation member 803 that becomes hot when the water-cooled accessory 900 is not attached.

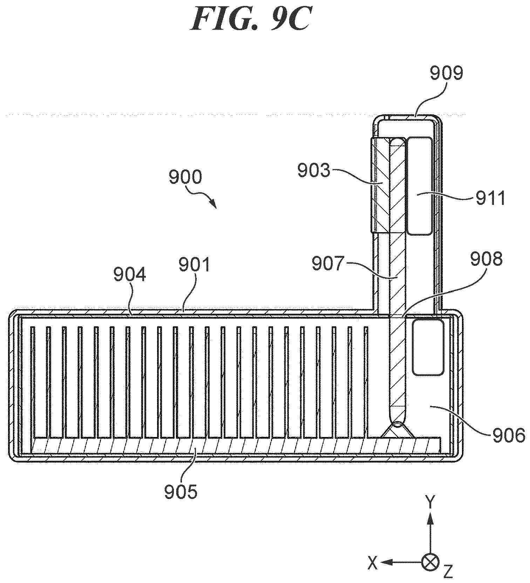

FIG. 9A is a rear perspective view showing the water-cooled accessory 900. FIG. 9B is a view showing the water-cooled accessory 900 viewed from the +Y side. FIG. 9C is a sectional view along a line D-D in FIG. 9B.

As shown in FIG. 9A, the water-cooled accessory 900 includes an accessory exterior 901, a tripod screw 902, and a tower portion 909. The tower portion 909 is provided to protrude from the accessory exterior 901 toward the +Y side. The tower portion 909 includes an accessory heat receiving member 903 and a power supply terminal 910.

The accessory heat receiving member 903 is exposed at a position where the accessory heat receiving member 903 can contact the heat dissipation member 803 in the tower portion 909. Although the accessory heat receiving member 903 is provided on the side surface of the tower portion 909 in the present embodiment, this is not limited, and the accessory heat receiving member 903 may be provided at any position of the tower portion 909 as long as the accessory heat receiving member can contact the heat dissipation member 803.

The water-cooled accessory 900 may be attached to the camera body 800 by threading a screw 902 of the water-cooled accessory 900 into the tripod mount 125 (FIG. 1C) of the camera body 800. When the water-cooled accessory 900 is attached to the camera body 800, the tower portion 909 is inserted into the battery chamber 801 of the camera body 800. Then, the heat dissipation member 803 of the camera body 800 and the accessory heat receiving member 903 of the water-cooled accessory 900 are brought into contact with each other and thermally connected.

In FIG. 9C, the tripod screw 902 and the power supply terminal 910 are hidden for simplicity. As shown in FIG. 9C, the water-cooled accessory 900 includes a power supply unit 911, a containment vessel 904 (containment unit) that contains a refrigerant 906, a heatsink 905 that transfers heat to the refrigerant 906 in the containment vessel 904, and a third heat transfer member 907. The third heat transfer member 907 is formed of a high thermal conductivity member such as a heat pipe. The third heat transfer member 907, the refrigerant 906, and the containment vessel 904 are housed in the accessory exterior 901. The third heat transfer member 907 is disposed from the tower portion 909 to the containment vessel 904.

The accessory heat receiving member 903 and the heatsink 905 are thermally connected by the third heat transfer member 907. The heat of the accessory heat receiving member 903 is transferred to the heatsink 905. The third heat transfer member 907 is not limited to the heat pipe, and may be a graphite sheet or a metal member. The third heat transfer member 907 is mounted through the containment vessel 904 and has a liquid seal 908 to prevent the refrigerant 906 inside the containment vessel 904 from leaking out.

The water-cooled accessory 900 includes a power supply unit 911. When the water-cooled accessory 900 is attached to the camera body 800, electric power is supplied from the power supply unit 911 to the camera body 800 via the power supply terminal 910 of the tower portion 909. The power supply unit 911 may be configured by a battery or an external power supply such as a USB power supply. Although the power supply unit 911 is provided in the tower portion 909 in the present embodiment, it may be disposed adjacent to the containment vessel 904. Further, the camera body 800 may include a built-in power supply without providing the power supply terminal 910 and the power supply unit 911 in the water-cooled accessory 900.

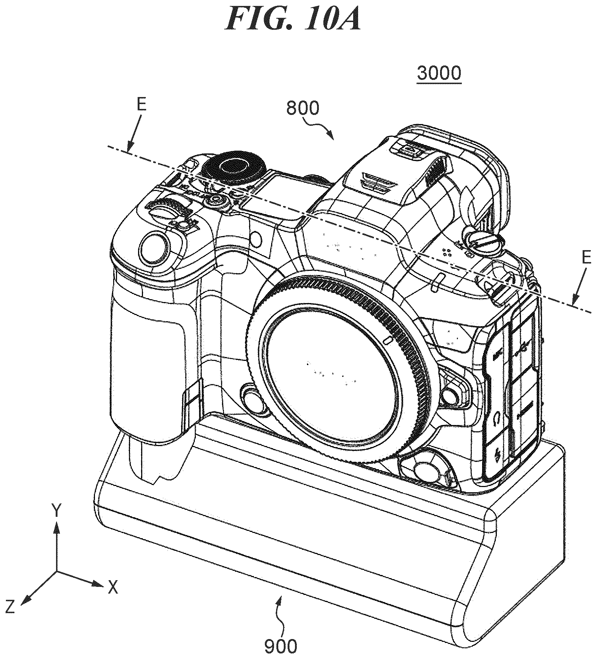

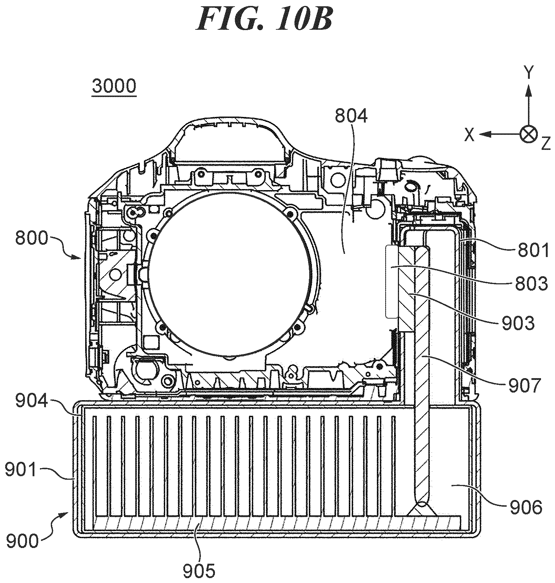

FIG. 10A is a front perspective view showing a camera system 3000 configured by attaching the water-cooled accessory 900 to the camera body 800. FIG. 10B is a sectional view along a line E-E in FIG. 10A. The water-cooled accessory 900 is configured to be attachable to and detachable from the bottom surface of the camera body 800.

A battery lid (not shown) is attached to the battery chamber 801 of the camera body 800 when the water-cooled accessory 900 is not attached. When the water-cooled accessory 900 is attached, the user removes the battery lid and inserts the tower portion 909 of the water-cooled accessory 900 into the battery chamber 801. The water-cooled accessory 900 may include a storage portion (not shown) in which the battery lid detached is stored.

When the water-cooled accessory 900 is attached to the camera body 800 and the tower portion 909 is inserted into the battery chamber 801, the heat dissipation member 803 and the accessory heat receiving member 903 are in contact with each other and thermally connected in the battery chamber 801. This allows transfer of the heat from the camera body 800 to the water-cooled accessory 900.

**In** the present embodiment, the heat dissipation member 803 is adjustably held by an elastic member (not shown). The insertion of the tower portion 909 finely adjusts the position of the heat dissipation member 803 in the horizontal direction (X direction) so that the heat dissipation member 803 and the accessory heat receiving member 903 are appropriately brought into contact with each other. Alternatively, the accessory heat receiving member 903 may be adjustably held by the third heat transfer member 907 having elasticity. In such a case, the insertion of the tower portion 909 adjusts the position of the accessory heat receiving member 903 in the horizontal direction (X direction) so as to contact the heat dissipation member 803. Alternatively, the accessory heat receiving member 903 may be disposed on a top surface (a tip end in the insertion direction) of the tower portion 909 so as to contact the heat dissipation member 803.

How heat is transferred will be described in detail. Heat of the image sensor 131 and the electronic components 133 of the camera body 800 is transferred to the heat dissipation member 803. In a state where the water-cooled accessory 900 is attached to the camera body 800, the heat of the heat dissipation member 803 is transmitted to the accessory heat receiving member 903 of the water-cooled accessory 900.

The heat transferred to the accessory heat receiving member 903 is transferred to the heatsink 905 via the third heat transfer member 907, and is further transferred from the heatsink 905 to the refrigerant 906. The heat of the refrigerant 906 is transferred to the containment vessel 904, transferred from the containment vessel 904 to the accessory exterior 901, and radiated from the outer surface of the accessory exterior 901 to the atmosphere. In contrast, a heat insulating structure that does not transfer the heat from the containment vessel 904 to the accessory exterior 901 may be employed.

According to the present embodiment, when the water-cooled accessory 900 is attached to the camera body 800, the heat dissipation member 803 and the accessory heat receiving member 903 are thermally connected to each other in the battery chamber 801, and the heat of the electronic components 133 is transferred to the refrigerant 906. Therefore, the same effect as that of the first embodiment can be achieved in cooling the camera body 800 while suppressing the dew condensation of the camera body 800 with a simple configuration.

Further, since the heat dissipation member 803 is provided in the battery chamber 801, it is not usually touched, and therefore, even when the water-cooled accessory 900 is not attached, the possibility that the user erroneously touches the heat dissipation member 803 and feels uncomfortable can be reduced.

The battery chamber 801 including the heat dissipation member 803 is relatively close to the first circuit board 130 on which the image sensor 131 as a heat source is mounted and the second circuit board 132 on which the electronic components 133 such as the CPU and the medium slot 153 are mounted. Therefore, it is easy to efficiently transfer the heat of the heat sources to the heat dissipation member 803.

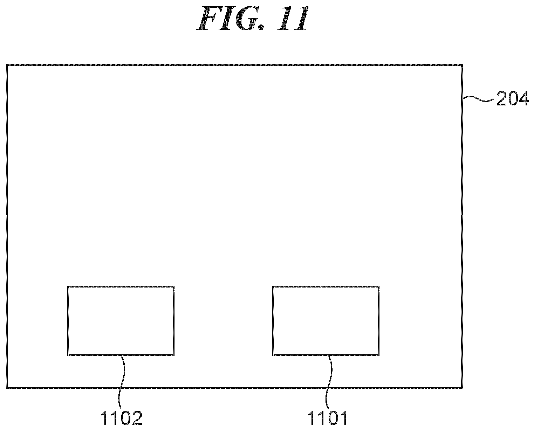

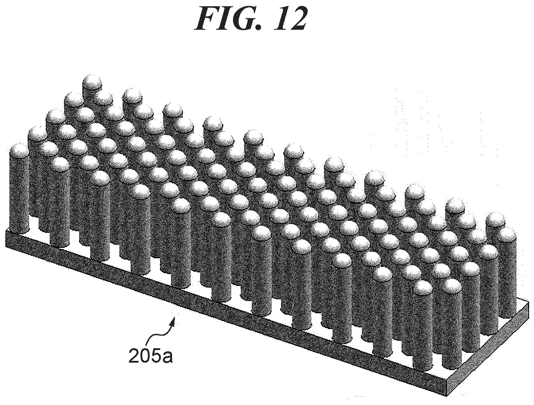

In each of the embodiments described above, modifications shown in FIGS. 11 and 12 may be applied.

FIG. 11 is a schematic view illustrating a modification of the containment vessel 204. In the first embodiment, a cooling mechanism 1101 (cooling unit) may be separately provided in the containment vessel 204 of the water-cooled accessory 200 to cool the refrigerant 206. The cooling mechanism 1101 is configured by, for example, a Peltier element, a fan, or a cooling rod that thermally connects the outside air and the refrigerant 206. The cooling mechanism 1101 can lower the temperature of the refrigerant 206, and the temperature of the camera body 100 can be further lowered.

A convection mechanism 1102 (convection unit) may be separately provided in the containment vessel 204. The convection mechanism 1102 is configured by, for example, a fan or a pump. The convection mechanism 1102 causes forced convection of the refrigerant 206 in the containment vessel 204. In a state where the camera body 100 and the water-cooled accessory 200 are not moved, circulation or forced convection does not occur, and thus temperature unevenness may occur in the refrigerant 206. When the convection mechanism 1102 generates the forced convection, the temperature unevenness in the refrigerant 206 is reduced and the temperature of the camera body 100 can be efficiently lowered.

Although the example in which the modification shown in FIG. 11 is applied to the containment vessel 204 in the first embodiment has been described, the modification is also applicable to the containment vessels 604 and 904 in the second and third embodiments.

FIG. 12 is a perspective view showing a heatsink 205a of a modification. The heatsink 205 shown in FIG. 2B has a configuration in which a plurality of wall-shaped fins are arranged. However, this is not limited, and columnar fins may be arranged at regular intervals as shown in FIG. 12. In this configuration, the refrigerant 206 can move between the columns regardless of the orientation of the heatsink 205a. Therefore, it is possible to reduce the temperature unevenness in the refrigerant 206 regardless of the orientation (posture) of the camera body 100 to which the water-cooled accessory 200 is attached.

Note that the modification shown in FIG. 12 is also applicable to the heatsinks 605 and 905 in the second and third embodiments. Each embodiment may employ at least one of the cooling mechanism 1101, the convection mechanism 1102, and the heatsink 205a with the columnar fins.

The image capturing apparatus to which the present disclosure is applied may be a lens-integrated apparatus. The present disclosure is also applicable to various electronic devices other than the image capturing apparatus.

Although the present disclosure has been described in detail based on the preferred embodiments thereof, the present disclosure is not limited to these specific embodiments, and various embodiments within a scope not departing from the gist of the present disclosure are also included in the present disclosure. Some of the above-described embodiments may be combined as appropriate.

### Other Embodiments

While the present disclosure has been described with reference to exemplary embodiments, it is to be understood that the disclosure is not limited to the disclosed exemplary embodiments. The scope of the following claims is to be accorded the broadest interpretation so as to encompass all such modifications and equivalent structures and functions.

## Claims

1. An electronic device (100, 500, 800) to which a cooling device (200, 600, 900) is detachably attachable, the electronic device comprising:
an electronic component (131, 133) as a heat source;
a heat dissipation member (135, 503, 803) having thermal conductivity; and
a first heat transfer member (134, 502, 802) configured to thermally connect the electronic component and the heat dissipation member,
wherein a heat receiving member (203, 603, 9030) of the cooling device and the heat dissipation member are thermally connected in a case where the cooling device is attached to the electronic device.

2. The electronic device (100) according to claim 1, wherein the cooling device (200) is attachable to a bottom surface of the electronic device, and
wherein a portion of the heat dissipation member (135) can be exposed from an exterior member (137) constituting a portion of the bottom surface in a case where the cooling device is attached to the bottom surface of the electronic device.

3. The electronic device (100) according to claim 2, further comprising a lid member (124) that is attachable to and detachable from the exterior member (137),
wherein the heat dissipation member (135) is not exposed from the exterior member in attaching the lid member to the exterior member, and the portion of the heat dissipation member is exposed from the exterior member in detaching the lid member from the exterior member.

4. The electronic device (500) according to claim 1, wherein the cooling device (600) is attachable to a rear surface of the electronic device, and
wherein a portion of the heat dissipation member (503) can be exposed from an exterior member (501) constituting a portion of the rear surface in a case where the cooling device (600) is attached to the rear surface of the electronic device.

5. The electronic device (500) according to claim 4, further comprising a display unit (101) movable between a position overlapping the rear surface and a position not overlapping the rear surface,
wherein the portion of the heat dissipation member (503) is not exposed when the display unit is in the position overlapping the rear surface, and the portion of the heat dissipation member is exposed when the display unit is in the position not overlapping the rear surface.

6. The electronic device (800) according to claim 1, wherein a portion of the heat dissipation member (803) is exposed in a battery chamber (801) that houses a battery, and
wherein a portion of the cooling device (900) including the heat receiving member (903) is inserted into the battery chamber (801) when the cooling device is attached to the electronic device so that the heat dissipation member and the heat receiving member (903) are thermally connected in the battery chamber.

7. The electronic device (100, 500, 800) according to any one of claims 1 to 6, further comprising:
a main construction (138, 504, 804) constituting a main body of the electronic device other than the heat dissipation member (135, 504, 804); and
a second heat transfer member (136, 505, 805) configured to thermally connect the heat dissipation member and the main construction.

8. The electronic device (100, 500, 800) according to claim 1, further comprising a tripod mount (125),
wherein the cooling device (200, 600, 900) is attached to the electronic device by screwing a screw (202, 902) of the cooling device into the tripod mount.

9. The electronic device (100, 500, 800) according to any one of claims 1 to 8, wherein the electronic device is an image capturing apparatus and the electronic component (131, 133) includes an image sensor (131) that converts an optical image into an image signal.

10. A cooling device (200, 600, 900) that is detachably attachable to an electronic device (100, 500, 800), the cooling device comprising:
a heat receiving member (203, 603, 903) partially exposed from an exterior member constituting an exterior of the cooling device; and
a containment vessel (204, 604, 904) configured to store a thermal diffuser (205, 605, 905) and a refrigerant (206, 606, 906);
wherein the heat receiving member and the thermal diffuser are thermally connected to each other, and the thermal diffuser and the refrigerant are thermally connected to each other, and
wherein a heat dissipation member (135, 503, 803) included in the electronic device and the heat receiving member are thermally connected to each other in a case where the cooling device is attached to the electronic device.

11. The cooling device (900) according to claim 10, wherein the portion of the heat dissipation member (803) exposed in a battery chamber (801) of the electronic device (800) and a portion of the cooling device including the heat receiving member (903) is inserted into the battery chamber (801) when the cooling device is attached to the electronic device so that the heat receiving member (903) is thermally connected to the heat dissipation member in the battery chamber.

12. The cooling device (200, 600, 900) according to claim 10, wherein the thermal diffuser (205, 605, 905) includes a plurality of fins for transferring heat to the refrigerant (206, 606, 906).

13. The cooling device (200) according to any one of claims 10 to 12, further comprising a cooling unit (1101) configured to cool the refrigerant.

14. The refrigeration device (200) according to any one of claims 10 to 13, further comprising a convection unit (1102) configured to cause convection of the refrigerant (206) in the containment vessel (204).

15. An electronic device system (1000, 2000, 3000) comprising:
an electronic device (100, 500, 800) comprising:
an electronic component (131, 133) as a heat source;
a heat dissipation member (135, 503, 803) having thermal conductivity; and
a first heat transfer member (134, 502, 802) configured to thermally connect the electronic component and the heat dissipation member; and
a cooling device (200, 600, 900) that is detachably attachable to the electronic device, the cooling device comprising:
a heat receiving member (203, 603, 903) partially exposed from an exterior member constituting an exterior of the cooling device; and
a containment vessel (204, 604, 904) configured to store a thermal diffuser (205, 605, 905) and a refrigerant (206, 606, 906);
wherein the heat receiving member and the thermal diffuser are thermally connected to each other, and the thermal diffuser and the refrigerant are thermally connected to each other, and
wherein the heat dissipation member of the electronic device and the heat receiving member of the cooling device are thermally connected to each other in a case where the cooling device is attached to the electronic device.
